# FASCICULE DE BREVET EUROPEEN

(11) **EP 3 577 685 B1**
(45) Date de publication et mention de la délivrance du brevet: **04.11.2020**
(21) Numéro de dépôt: 18705432.5
(22) Date de dépôt: 29.01.2018
(51) Int. Cl.: H01L 23/427, H01L 23/473, H01L 23/373

(54) **MODULE ÉLECTRONIQUE DE PUISSANCE COMPORTANT UN SUPPORT DIÉLECTRIQUE**
ELEKTRONISCHES LEISTUNGSMODUL MIT DIELEKTRISCHEM TRÄGER
ELECTRONIC POWER MODULE COMPRISING A DIELECTRIC SUPPORT

(30) Priorité: 31.01.2017 FR 1750774
(43) Date de publication de la demande: 11.12.2019
(73) Titulaire: Supergrid Institute, 69100 Villeurbanne (FR); Université Claude Bernard Lyon 1, 69100 Villeurbanne (FR); Ecole Centrale de Lyon, 69130 Ecully (FR); Institut National des Sciences Appliquées de Lyon, 69100 Villeurbanne (FR); Centre National de la Recherche Scientifique, 75016 Paris (FR)
(72) Inventeur: BUTTAY, Cyril, 69372 Lyon Cedex 08 (FR)
(74) Mandataire: Opilex
(86) Numéro de dépôt international: PCT/FR2018/050197
(87) Numéro de publication internationale: WO 2018/142053

(56) Documents cités:
- DE-A1-102011 089 891

## Description

L'invention a trait au domaine de l'électronique de puissance et concerne plus particulièrement la commutation de circuits de puissance dont la tension élevée génère des contraintes en matière de dissipation thermique et d'isolation électrique.

Les tensions élevées induisent en effet des problématiques liées, d'une part, à la nécessité de dissiper de la chaleur produite par le travail des composants de puissance et liées, d'autre part, à la nécessité d'isolation électrique des éléments soumis à d'importantes différences de potentiel.

L'électronique de puissance a pour but de modifier la présentation de l'énergie électrique avec un rendement maximum. Il s'agit notamment de transformer l'alternatif en continu (montages redresseurs), transformer le continu en alternatif (montages onduleurs), modifier la valeur efficace d'une tension alternative (montages gradateurs), modifier la valeur moyenne d'une tension continue (montages hacheurs), modifier la fréquence d'une tension alternative (montage cycloconvertisseurs).

Dans ce domaine, on utilise couramment des modules électroniques de puissance se présentant généralement sous forme d'un boîtier muni de bornes de connexion et contenant un ou plusieurs semi-conducteurs de puissance reliés aux bornes de connexion par des conducteurs de raccordement. Les semi-conducteurs de puissance dégagent de la chaleur parce qu'ils travaillent sur des niveaux élevés de tension, d'intensité et/ou de fréquence de commutation. L'échauffement résultant est significatif et il est nécessaire de prévoir des dispositifs actifs ou passifs de dissipation thermique pour le bon fonctionnement et la sécurité des modules électroniques de puissance. Par ailleurs, pour les tensions élevées, une importante différence de potentiel est générée entre les conducteurs de raccordement ce qui nécessite une isolation électrique pour empêcher la formation d'arcs électriques, voire la destruction du module.

La solution couramment employée pour résoudre les problèmes de dissipation thermique et d'isolation électrique consiste à monter chaque semi-conducteur et ses conducteurs de raccordement sur un substrat de support, généralement en céramique, qui est isolant électrique et qui présente des caractéristiques satisfaisantes de conduction thermique. La céramique est par ailleurs en contact avec un dispositif de refroidissement de sorte que la chaleur à dissiper se diffuse dans la céramique jusqu'au dispositif de refroidissement qui dissipe la chaleur reçue vers un fluide caloporteur (air, eau, ou autre fluide).

De nouvelles problématiques apparaissent aujourd'hui avec, entre autres, la multiplication des sources d'énergie, notamment la production d'énergies renouvelables, et le raccordement au réseau de ces énergies. La production d'énergie à partir de sources hétérogènes telles que éoliennes (courant alternatif) ou panneaux photovoltaïques (courant continu), impose l'introduction de pôles de conversion du courant alternatif en courant continu, ou l'inverse, au sein du réseau électrique de distribution. La distribution de cette énergie impose également de repenser le réseau lui-même, par exemple en prévoyant des réseaux de transport de courant continu à haute tension. Ceci conduit notamment à introduire des modules électroniques de puissance au sein des réseaux électriques pour de nouveaux besoins et à commuter du courant continu, plus sévère en matière d'isolation, à des tensions élevées. A ces nouvelles contraintes s'ajoute la tendance continue visant à diminuer les dimensions des modules électroniques de puissance et/ou à augmenter la densité de semi-conducteurs qu'ils contiennent, et ce quelque soit le domaine d'application.

Ces nouvelles problématiques exigent pour les modules électroniques de puissance une capacité plus importante à dissiper la chaleur et, simultanément, une meilleure isolation électrique.

Les céramiques employées dans l'art antérieur pour la réalisation des substrats de support, par exemple l'alumine ou le nitrure de bore, présentent les meilleures performances en matière de conductivité thermique (pour la dissipation de la chaleur) et d'isolation électrique, pour un coût compatible avec l'industrie de l'électronique de puissance. Il existe des matériaux présentant de meilleures performances que ces céramiques à la fois sur le plan de la conductivité et sur le plan de l'isolation, mais ils sont soit d'un coût prohibitif les excluant des applications électroniques (comme par exemple le diamant), soit toxiques ou présentant un danger pour l'environnement et les excluant donc également de ces applications (comme par exemple l'oxyde de béryllium).

En conséquence, la solution courante pour améliorer l'isolation électrique des modules électroniques de puissance de l'art antérieur consiste à augmenter l'épaisseur du substrat de support lorsqu'ils sont soumis à des conditions plus sévères. Cependant, cette augmentation d'épaisseur entraîne également une dégradation de la capacité à dissiper la chaleur puisque la chaleur doit dorénavant traverser une épaisseur plus importante de substrat avant d'être évacuée par un fluide caloporteur. La conductivité thermique du matériau du substrat, bien qu'élevée, est loin d'être idéale et jouer sur son épaisseur revient à mettre en conflit la fonction de dissipation thermique avec la fonction d'isolation électrique. Favoriser l'une conduit à dégrader l'autre.

Le document US8432030 décrit un module électronique de puissance où ce problème est atténué par l'augmentation de la capacité de dissipation thermique du module grâce à un second dispositif de refroidissement. Cette solution propose un dispositif de refroidissement classique coopérant avec le substrat de support d'un semi-conducteur et propose de plus un second dispositif de refroidissement agissant sur la face opposée du semi-conducteur. Le doublement des moyens de refroidissent procure mathématiquement une meilleure dissipation thermique mais constitue une solution plus complexe, coûteuse, et encombrante.

Le document EP2277365 décrit un système de refroidissement pour modules électroniques de puissance mettant en œuvre une solution comparable à la précédente, où deux dispositifs de refroidissement agissent de part et d'autre d'un semi-conducteur. La capacité de dissipation de la chaleur est également augmentée grâce à l'emploi d'un fluide diphasique comme fluide caloporteur. Le fluide diphasique ayant une faible température d'ébullition, il passe de l'état liquide à l'état gazeux au contact des éléments à refroidir, le changement de phase augmentant les performances de refroidissement. Cette solution permet également d'augmenter la capacité de refroidissement du module au prix d'une complexité accrue.

Le document DE 10 2011 089891 A1 (CONTINENTAL AUTOMOTIVE GMBH [DE]) 27 juin 2013 (2013-06-27) décrit un module de puissance dans lequel la chaleur est dissipée à travers une céramique et un fluide.

Dans les différents modules de refroidissement de l'art antérieur tels que ceux décrits ci-dessus, des conditions plus sévères exigeant une augmentation des performances en matière d'isolation électrique conduisent à une augmentation de l'épaisseur du substrat de support qui provoque elle-même une dégradation des performances de refroidissement et cette dégradation est ensuite palliée par les dispositifs de refroidissements plus complexes décrits plus haut.

L'invention a pour but d'améliorer les modules électroniques de puissance de l'art antérieur.

A cet effet, l'invention vise un module électronique de puissance comportant au moins un semi-conducteur relié à des conducteurs de raccordement, et qui comporte également un support diélectrique présentant d'une part une couche fixe, sur laquelle est monté au moins un desdits conducteurs de raccordement, et présentant d'autre part une couche mobile, la couche fixe et la couche mobile étant de permittivité diélectrique semblable et se superposant selon au moins une surface en vis-à-vis du au moins un conducteur de raccordement.

La permittivité d'un matériau, exprimée en coulombs par volt et par mètre (C.V⁻¹.m⁻¹) ou en farads par mètre (F.m⁻¹), permet de mesurer l'influence d'un champ électrique sur ce matériau. Cette permittivité diélectrique peut également être exprimée par une quantité adimensionnelle dénommée « permittivité relative » ou « constante diélectrique du matériau » qui est le facteur par lequel la permittivité diélectrique du vide est multipliée pour obtenir la permittivité diélectrique du matériau concerné.

La caractéristique selon laquelle la couche fixe et la couche mobile sont de permittivité diélectrique semblable implique que la permittivité diélectrique de la couche fixe et la permittivité diélectrique de la couche mobile ont des valeurs suffisamment proches pour que l'ensemble formé par ces deux couches superposées ait un comportement homogène lorsque soumis à un champ électrique, ce qui permet une répartition homogène des gradients de potentiels électriques sur l'ensemble de l'épaisseur du support diélectrique. La permittivité diélectrique de la couche fixe et la permittivité diélectrique de la couche mobile sont donc égales ou suffisamment proches pour permettre ce comportement homogène. Les phénomènes de claquage, et plus généralement de dégradation des modules sous l'effet d'une tension élevée, sont favorisés dans les zones de pic de potentiel créées par exemple par des angles vifs. A l'inverse, une répartition homogène des gradients de potentiel permet d'éviter ces phénomènes.

Selon une caractéristique préférée, les permittivités diélectriques respectives des couches du support diélectriques sont dites semblables lorsque l'écart entre la permittivité diélectrique de la couche mobile et la permittivité diélectrique de la couche fixe est inférieur à 50 %, voire à 20 %, de la permittivité diélectrique de la couche fixe.

La disposition du support diélectrique en couches et l'homogénéisation des permittivités diélectriques permettent une répartition optimale des gradients de potentiel électrique lorsque le support diélectrique est soumis à un champ électrique, de sorte que les capacités d'isolation électrique du support diélectrique sont améliorées quelle que soit l'épaisseur de la couche fixe, cette dernière pouvant donc être dimensionnée pour favoriser l'échange thermique, c'est à dire rendue plus fine.

L'invention va à rencontre du raisonnement courant dans le domaine technique car elle propose de décorréler la performance en matière de refroidissement de la performance en matière d'isolation électrique, de sorte que l'augmentation de l'une ne dégrade pas l'autre. Les fonctions de substrat de support et de dispositif de refroidissement de l'art antérieur sont ici assurées par un seul et même support diélectrique dont les deux couches, l'une fixe, l'autre mobile, participent chacune aux deux fonctions de refroidissement et d'isolation sans que ces fonctions ne soient mises en conflit.

Par ailleurs, une autre caractéristique physique joue un rôle dans la distribution du champ électrique dans un matériau, en particulier lorsque la tension à isoler est continue : sa conductivité électrique. Selon une autre caractéristique, le module électronique de puissance peut avoir une couche fixe et une couche mobile qui présentent des conductivités électriques comparables. La conductivité électrique variant sur une large plage pour les isolants (10⁻⁸ à 10⁻²⁰ S.m⁻¹), on considérera que les conductivités électriques de la couche fixe et de la couche mobile sont comparables lorsqu'elles sont inclues dans un rapport 10, c'est à dire lorsque la conductivité électrique la plus élevée est inférieure à dix fois la conductivité électrique la moins élevée.

Le module électronique de puissance peut comporter les caractéristiques additionnelles suivantes, seules ou en combinaison :
- le module électronique de puissance comporte en outre un gel de remplissage disposé autour du semi-conducteur et des conducteurs de raccordement, ce gel de remplissage ayant une permittivité diélectrique semblable à celle de la couche fixe ;
- la couche mobile est en contact avec la couche fixe suivant une interface de contact texturée ;
- la couche fixe est composée d'un substrat de céramique diélectrique ;
- la couche mobile est composée d'un fluide diélectrique ;
- le fluide diélectrique de la couche mobile est contenu dans une chambre s'étendant suivant toute la surface de la couche fixe, la couche fixe et la couche mobile ayant ainsi des surfaces égales qui se superposent ; ou, alternativement, le fluide de la couche mobile est contenu dans une ou plusieurs chambres restreintes s'étendant seulement suivant la surface en regard du au moins un conducteur de raccordement, la couche fixe et la couche mobile se superposant ainsi sur toute la surface en regard du au moins un conducteur de raccordement ;
- ladite ou lesdites chambres sont des chambres fermées, où la mobilité du fluide est assurée par convection naturelle ; ou, alternativement, la ou lesdites chambres sont connectées à un circuit de refroidissement ;
- le fluide de la couche mobile présente une température d'ébullition inférieure à la température du module électronique de puissance en fonctionnement, de sorte à assurer un refroidissement diphasique.

Quel que soit le matériau de la couche fixe, l'invention permet de réduire l'épaisseur de cette dernière, même en cas d'augmentation de la nécessité d'isolation, et permet de réduire cette épaisseur jusqu'à ce qu'elle soit inférieure à l'épaisseur minimale imposée par sa tension de claquage, ici appelée « épaisseur critique d'isolation ». Par exemple, si la tension de claquage de la céramique employée pour la couche fixe du support diélectrique est de 25 kV/mm (incluant les coefficients de sécurité usuels), alors l'épaisseur critique d'isolation sera de 1 mm pour un module prévu pour 25 kV. L'épaisseur de la couche fixe pourra dans ce cas être inférieure à 1 mm. L'action d'isolation de la couche fixe est alors complétée par la couche mobile, quelle qu'en soit le matériau, solide ou fluide, pour atteindre le niveau requis.

Ainsi la couche fixe peut présenter une épaisseur inférieure à l'épaisseur critique d'isolation, compte tenu de la rigidité diélectrique de la couche fixe et de la tension maximale du module électronique de puissance, c'est à dire la tension maximale qui peut être appliquée aux conducteurs de raccordement, tandis que la somme de l'épaisseur de la couche fixe et de l'épaisseur de la couche mobile est supérieure à ladite épaisseur critique d'isolation.

Un exemple préféré de réalisation de l'invention va maintenant être décrit en références aux dessins annexés dans lesquels :
- la figure 1 est une vue en coupe d'un module électronique de puissance selon l'invention ;
- la figure 2 est une vue de dessus du module électronique de puissance de la figure 1 ;
- la figure 3 est une vue de de dessus du module électronique de puissance de la figure 1 sans son boîtier ;
- la figure 4 est une vue de dessous du module électronique de puissance de la figure 1 ;
- la figure 5 représente schématiquement le circuit de fluide caloporteur du module électronique de puissance de la figure 1 ;
- la figure 6 est une vue partielle et en coupe de certains éléments de la figure 1, montrant la répartition du potentiel électrique dans le support diélectrique ;
- la figure 7 est similaire à la figure 5, pour un module électronique de puissance de l'art antérieur ;
- la figure 8 est une vue de dessous d'une variante de réalisation du module électronique de puissance selon l'invention ;
- la figure 9 est une vue en coupe du module électronique de puissance selon la variante de la figure 8.

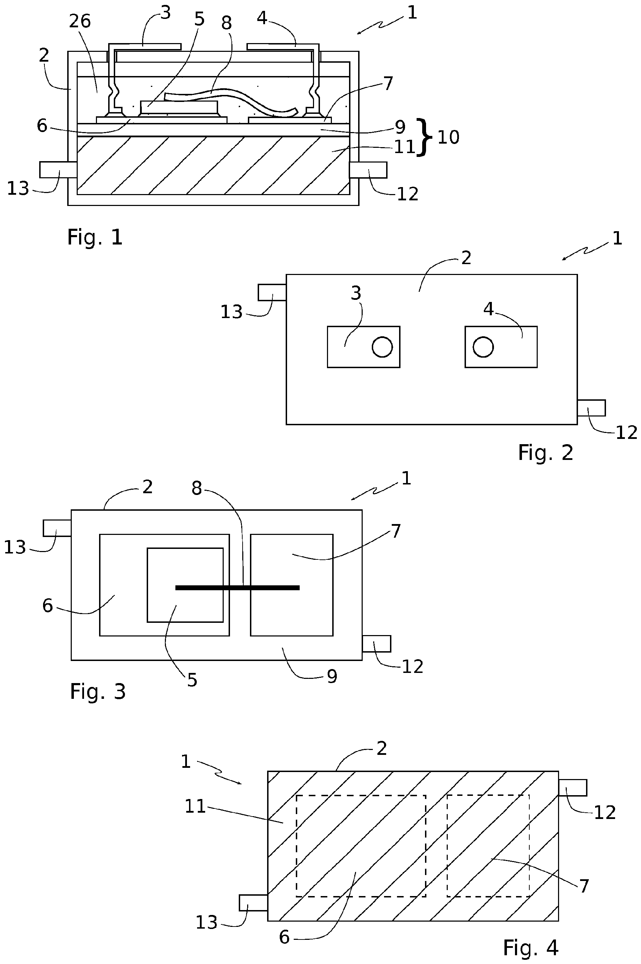

Les figures 1 à 4 représentent un module électronique de puissance 1 selon l'invention. Il comporte un boîtier 2 muni d'une première borne 3 et d'une deuxième borne 4 destinées à la connexion du module 1. Pour simplifier la description, le module électronique de puissance 1 est un module simple comportant deux bornes 3, 4 et un unique semi-conducteur 5 muni de deux pôles.

La vue de dessus de la figure 2 montre les deux bornes 3, 4 accessibles depuis l'extérieur du boîtier 2 pour relier électriquement le module 1 au circuit pour lequel il est prévu. La première borne 3 et la deuxième borne 4 sont respectivement reliées, à l'intérieur du module 1, à un premier conducteur de raccordement 6 et à un deuxième conducteur de raccordement 7. Le semi-conducteur 5 qui, dans le présent exemple présente deux pôles, est connecté à chacun des conducteurs de raccordement 6, 7. Le semi-conducteur 5 est ainsi raccordé par une de ses faces au premier conducteur de raccordement 6 via un fil soudé 8, réalisant la jonction de son premier pôle, et est lui-même soudé par sa face opposée au deuxième conducteur de raccordement 7, réalisant la jonction de son deuxième pôle.

Les deux conducteurs de raccordement 6, 7 sont, dans le présent exemple, deux rectangles de cuivre comme montré sur la figure 3 qui est une vue de dessus du module 1 sans boîtier. Ces deux conducteurs de raccordement 6, 7 sont montés sur la couche fixe 9 d'un support diélectrique 10 qui comporte également une couche mobile 11 sous la couche fixe 9. La couche mobile 11 est représentée hachurée pour plus de clarté. La couche fixe 9 et la couche mobile 11 du support diélectrique 10 sont, dans le présent exemple, des parallélépipèdes dont l'épaisseur est visible à la figure 1 et dont la longueur et la largeur sont visibles à la figure 4 (dans la vue de dessous de la figure 4, représentant le module 1 sans boîtier, le support diélectrique 10 occupe la surface hachurée).

La couche fixe 9 assure la fixation et le support mécanique du semi-conducteur 5, et assure également la conduction thermique vers la couche mobile 11 de la chaleur dégagée par le semi-conducteur 5. Elle contribue de plus, mais seulement en partie, à l'isolation électrique entre les conducteurs de raccordement 6, 7.

La couche fixe 9 présente ainsi une épaisseur qui peut être simplement suffisante pour la tenue mécanique du semi-conducteur 5, sans être dictée par les impératifs de l'isolation électrique. Elle peut notamment être d'une épaisseur insuffisante pour garantir a elle seule la rigidité diélectrique nécessaire lorsque le module 1 est connecté suivant une tension donnée, dans la mesure où la couche mobile participe également à la rigidité diélectrique comme expliqué ci-dessous.

La couche mobile 11, quant à elle, assure ou complète l'isolation électrique évitant les arcs électriques au sein du module 1, et assure également l'évacuation de la chaleur reçue de la couche fixe 9.

La fonction d'isolation électrique de la couche mobile 11 est remplie par le fait que cette dernière est directement en contact avec la couche fixe 9 et par le choix de son matériau de réalisation qui présente des propriétés de réaction à l'influence d'un champ électrique semblables à celles de la couche fixe 9, ce qui se traduit par une permittivité diélectrique de la couche fixe 9 semblable à la permittivité diélectrique de la couche mobile 11. La couche fixe 9 et la couche mobile 11 forment ensemble un isolant cohérent d'une épaisseur totale à dimensionner pour être suffisante en fonction de la rigidité diélectrique nécessaire face à une tension donnée qui serait appliquée au module 1 par la connexion de ses bornes 3, 4 à un circuit. L'épaisseur totale du support diélectrique 10 correspond à l'épaisseur de la couche fixe 9 et de la couche mobile 11 ensemble.

Selon une variante non représentée, la couche mobile est en contact avec la couche fixe suivant une interface de contact texturée. La couche fixe peut ainsi comporter une texture de types ailettes, chicanes, ou un quelconque autre motif, pour favoriser l'imbrication de la couche fixe et de la couche mobile.

Selon une autre variante, le matériau de la couche mobile 11 présente de plus une conductivité électrique comparable à la conductivité thermique de la couche fixe 9, de sorte à favoriser également la répartition du champs électrique suivant l'épaisseur du support diélectrique 10. Les conductivités électriques de la couche fixe 9 et de la couche mobile 11 sont donc ici contenues dans un facteur 10.

Dans le présent exemple, le matériau choisi pour la réalisation de la couche mobile 11 est un fluide diélectrique qui est contenu dans une chambre délimitée par la couche fixe 9 et par le boîtier 2 (voir figure 1). La couche mobile 11 s'étend suivant toute la surface de la couche fixe 9, la couche fixe 9 et la couche mobile 11 ayant ainsi une surface égale et se superposant suivant toute cette surface. La fonction d'évacuation de la chaleur est remplie par le déplacement de la couche mobile 11 réalisé grâce à une entrée de fluide 12 et une sortie de fluide 13, branchées à un circuit de refroidissement qui organise une circulation du fluide permettant l'évacuation des calories.

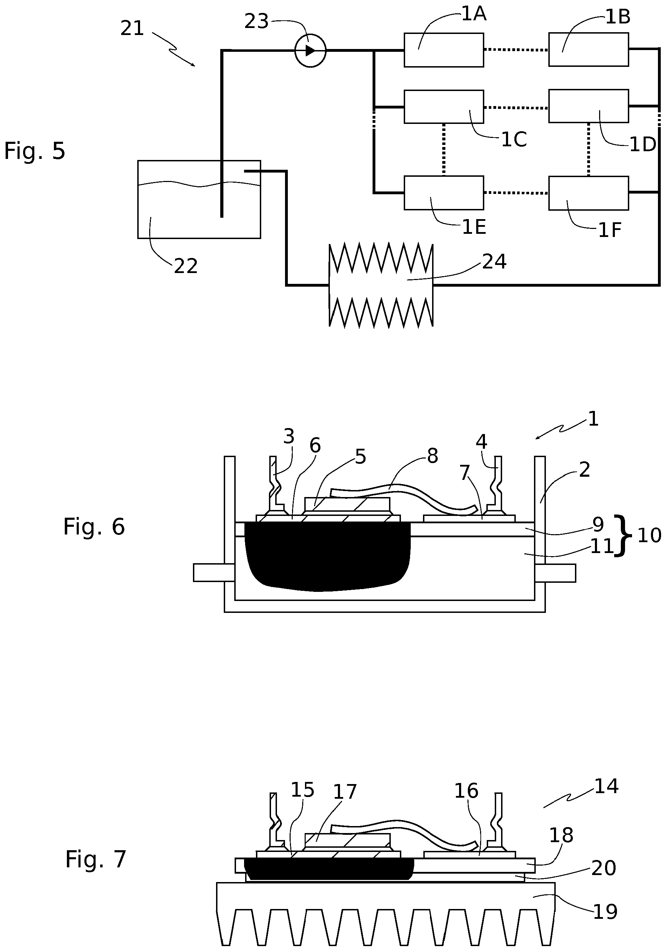

Un tel circuit de refroidissement 21 est représenté à la figure 5. Il permet la circulation du fluide composant la couche mobile 11 pour assurer l'évacuation des calories du module électronique de puissance 1. Le circuit de refroidissement 21 comporte, dans l'exemple illustré, un réservoir 22 et une pompe 23 qui permet la circulation du fluide dans autant de modules électroniques de puissance 1 que nécessaire. Un seul circuit de refroidissement 21 peut en effet être prévu pour une installation comportant plusieurs modules 1. Les modules électroniques de puissance 1A, 1B, 1C, 1D, 1E, 1F de la figure 5 bénéficient ainsi du même fluide pour constituer leur couche mobile 11 respective. Les liaisons en pointillés entre ces modules électroniques de puissance 1A, 1B, 1C, 1D, 1E, 1F indiquent que la circulation du fluide peut avoir lieu dans les modules connectés en série, et/ou en parallèle.

Le fluide peut de plus être choisi pour avoir un comportement diphasique et le circuit de refroidissement 21 comporte dans ce cas un condenseur 24. Un tel fluide diphasique présente une température d'ébullition inférieure à celle à laquelle il est soumis dans les modules électronique de puissance 1A, 1B, 1C, 1D, 1E, 1F. Le fluide sort ainsi à l'état liquide de la pompe 23, et se vaporise au moins en partie dans les modules électroniques de puissance 1A, 1B, 1C, 1D, 1E, 1F, puis revient à l'état liquide dans le condenseur 24. La couche mobile 11 du module électronique de puissance 1 est dans ce cas constituée de fluide liquide, gazeux ou d'une combinaison des deux.

Alternativement, le fluide peut rester confiné dans la chambre délimitant la couche mobile 11, sans circuit de refroidissement 21, de sorte que le déplacement du fluide a lieu en tirant partie de la convection naturelle qui engendre des mouvements entre le fluide à proximité de la couche fixe 9, plus chaud, et le fluide plus éloigné de la couche fixe 9, plus froid. Ce mouvement interne du fluide suffit pour rendre mobile la couche mobile 11 lorsque les besoins en dissipation thermique sont limités, c'est à dire pour un semi-conducteur 5 dont réchauffement est réduit.

Dans tout les cas, le refroidissement peut être amélioré par toute caractéristique additionnelle connues pour augmenter la dissipation thermique, telles que des ailettes de dissipation thermique sur le boîtier 2.

Selon une alternative non représentée, plutôt qu'une couche mobile 11 fluide, la couche mobile 11 peut être réalisée sous forme d'une lame de matériau flexible ou rigide animée d'un mouvement relatif avec la couche fixe 9 de sorte de le glissement entre cette lame de matériau et la couche fixe 9 permet d'évacuer au fur et à mesure les calories.

La couche mobile 11 peut donc être constituée d'un matériau solide, liquide, gazeux, rigide ou flexible, ou d'une combinaison de ceux-ci. Quelle que soit la constitution de la couche mobile 11, celle-ci présente une mobilité relative à la couche fixe 9 de sorte que le support diélectrique 10 permette l'évacuation de la chaleur produite par le semi-conducteur 17.

Le matériau constituant la couche mobile 11 présente de plus une permittivité diélectrique semblable à celle du matériau constituant la couche fixe 9. Dans le présent exemple, le matériau choisi pour constituer la couche fixe 9 est un nitrure d'aluminium dont la permittivité relative est égale à 8,5 et le matériau choisi pour constituer la couche mobile 11 est un fluide fluorocétone dont la permittivité relative est égale à 7. L'écart entre les valeurs de permittivité diélectrique de la couche fixe 9 et de la couche mobile 11 ne dépasse ainsi pas 20 % de la permittivité diélectrique de la couche fixe 9. Alternativement, cet écart peut aller jusqu'à 50 % de la permittivité diélectrique de la couche fixe 9. Le support diélectrique 10 forme ainsi un ensemble uniforme en matière de permittivité diélectrique, ayant un comportement homogène en présence d'un champ électrique.

Le module électronique de puissance 1 peut optionnellement comporter un gel 26 diélectrique de remplissage noyant le semi-conducteur 5 et ses connexions (le gel 26 est représenté sur la figure 1). Le matériau du gel 26 peut également être choisi pour avoir une permittivité diélectrique semblable à la permittivité diélectrique de la couche fixe 11, de sorte que l'ensemble formé par le support diélectrique 10 et le gel 26 a un comportement uniforme en présence d'un champ électrique. Les avantages à disposer d'un ensemble cohérent en matière de permittivité diélectrique pour la couche fixe 9 et la couche mobile 11, peuvent ainsi être étendus à l'ensemble formé par la couche fixe 9, la couche mobile 11, et le gel 26. De même que précédemment, la permittivité diélectrique du gel 26 est dite semblable à celle de la couche fixe 9 lorsque l'écart entre ces dernières ne dépasse pas 20 %, et alternativement 50 %, de la permittivité diélectrique de la couche fixe 9.

La vue de la figue 6, qui est similaire à la figure 1, montre de manière schématique la répartition du potentiel électrique dans le support diélectrique 10. On considère, dans le présent exemple, que l'on connecte le module électronique de puissance 1 de telle sorte que la première borne 3, et donc le premier conducteur de raccordement 6, sont mis au potentiel 0, tandis que la deuxième borne 4, et donc le deuxième conducteur de raccordement 7, sont mis à un potentiel élevé, par exemple 5000 V en courant continu.

Un gradient de potentiel électrique apparaît alors dans les matériaux qui constituent le module électronique de puissance 1, entre les éléments au potentiel 0 (représentés hachurés sur la figure 6) et les éléments au potentiel 5000V (représentés non hachurés sur la figure 6). Le gradient de potentiel électrique dans le support diélectrique 10 est représenté sous la forme d'un dégradé sur la figure 6, où le passage du plus foncé au plus clair schématise le passage du potentiel électrique le plus important (5000 V) au potentiel électrique le plus faible (0 V). Le module électronique de puissance 1 permet une diffusion optimale du potentiel électrique en permettant au gradient de potentiel électrique de se répartir suivant toute l'épaisseur du support diélectrique 10 qui, malgré sa réalisation en deux couches 9, 11 forme un ensemble uniforme en matière de permittivité diélectrique, propice à une telle répartition homogène du gradient de potentiel électrique.

La figue 7 est une vue similaire à la figure 6 mais qui représente un module électronique de puissance 14 de l'art antérieur. Les figures 6 et 7 permettent de mettre en parallèle la répartition du potentiel électrique selon l'invention et selon l'art antérieur. En référence à la figure 7, le module électronique de puissance 14 de l'art antérieur comporte un semi-conducteur 17 connecté à un premier conducteur de raccordement 15 et à un deuxième conducteur de raccordement 16. Ces conducteurs de raccordement 15, 16 sont montés sur un substrat de support 18 isolant qui est muni, sur sa face opposée, d'un dispositif de refroidissement 19. Un pont thermique 20 en cuivre assure la liaison thermique entre le substrat de support 18 et le dispositif de refroidissement 19 qui peut être passif (comme représenté sur la figure 7) ou actif (grâce à la circulation d'un fluide caloporteur dans le dispositif de refroidissement 19).

Dans les mêmes conditions que précédemment (premier conducteur de raccordement 15 au potentiel 0V et deuxième conducteur de raccordement 16 au potentiel 5000 V en courant continu), le gradient de potentiel électrique est également schématisé par un dégradé sur cette figure 7 représentant l'art antérieur. Le substrat de support 18 remplit la double fonction de conduire la chaleur à dissiper entre le semi-conducteur 17 et le dispositif de refroidissement 19, et d'assurer en totalité l'isolation électrique des conducteurs de raccordement 15, 16. Le potentiel électrique ne peut donc se répartir que suivant l'épaisseur du substrat de support 18. A l'endroit précis où la base du substrat de support 18 touche le pont thermique 20, le potentiel électrique doit avoir atteint la valeur 0.

Cette figure 7 qui illustre l'art antérieur permet, par comparaison, de mettre en lumière la répartition avantageuse du potentiel électrique sur une épaisseur plus importante, permise par l'invention illustrée à la figures 6.

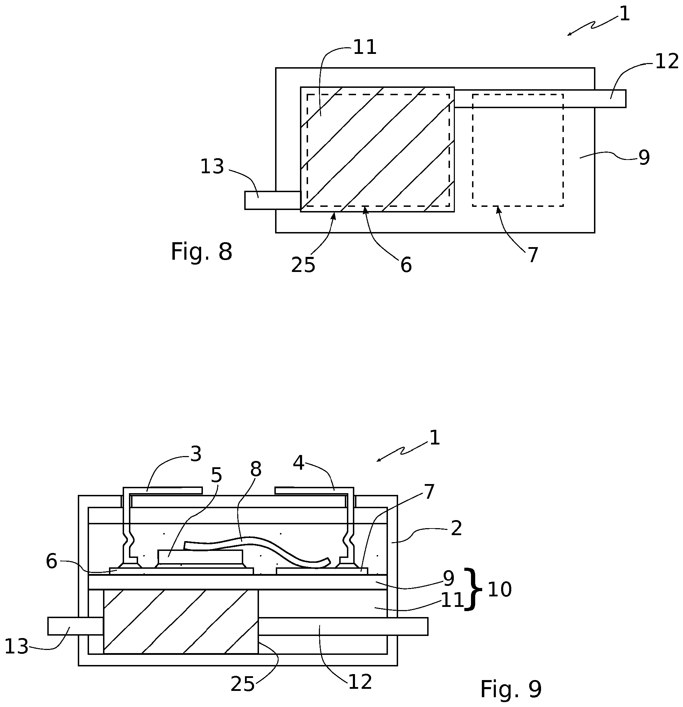

Les figures 8 et 9 sont relatives à une variante de réalisation de la couche mobile du module électronique de puissance selon l'invention. Elles sont similaires respectivement aux figures 4 et 1 et les éléments correspondants sont numérotés de la même manière.

Le module de puissance 1 selon cette variante de réalisation comporte également un semi-conducteur 5 relié à un premier conducteur de raccordement 6 et un deuxième conducteur raccordement 7, le tout étant monté sur un support diélectrique 10 constitué d'une couche fixe 9 et d'une couche mobile 11. La variante de réalisation vise spécifiquement la couche mobile 11 qui est ici restreinte à la superficie en regard du premier conducteur de raccordement 6. La figure 8 est une vue de dessous du module électronique de puissance 1, schématiquement dépourvu de son boîtier 2, qui montre en pointillés les contours du premier conducteur de raccordement 6 et du deuxième conducteur de raccordement 7. Une enceinte 25 délimite la chambre occupée par la couche mobile 11, cette chambre s'étendant sur toute la surface en regard du contour du premier conducteur de raccordement 6 (voir figure 8). De cette manière, la couche fixe 9 et la couche mobile 11 se superposent en vis-à-vis du conducteur de raccordement 6 (voir figure 9). Autrement dit, à l'extérieur du contour délimité par le premier conducteur de raccordement 6, le support diélectrique 10 ne comporte qu'une seule couche constituée par la couche fixe 9, tandis qu'à l'intérieur de ce contour, le support diélectrique 10 est constitué de la couche fixe 9 et de la couche mobile 11 superposées. L'entrée de fluide 12 et la sortie de fluide 13 sont agencées en conséquence pour permettre la canalisation du fluide jusqu'à l'enceinte 25.

L'agencement du support diélectrique 10 selon la variante des figures 8 et 9 est prévu pour un branchement comparable à celui de l'exemple de la figure 6, c'est à dire pour la mise au potentiel 0 du deuxième conducteur de raccordement 7 et la mise à un potentiel élevé du premier conducteur de raccordement 6. La répartition du potentiel électrique se fera alors dans les deux couches 9, 11 du support diélectrique 10, de manière similaire à ce qui est montré figure 6.

A l'image de la variante de réalisation des figures 8 et 9, le support diélectrique peut être constitué d'une seule couche fixe étendue et d'une ou plusieurs couches mobiles restreintes disposées en regard du ou des conducteurs de raccordement pour lesquels il est nécessaire de prévoir de l'espace pour la répartition du potentiel électrique.

D'autres variantes de réalisation du module électronique de puissance peuvent être mises en œuvre sans sortir du cadre de l'invention. Par exemple, la couche fixe 9 et la couche mobile 11 peuvent avoir des formes plus complexes que les simples rectangles décrits ici pour faciliter la compréhension, de même que les conducteurs de raccordement 6, 7. Par ailleurs, au-delà de l'exemple simple illustré ici, le module électronique de puissance 1 peut comporter une pluralité, voire un nombre très important, de conducteurs de raccordement 6, 7 et de semi-conducteurs correspondants, qui peuvent être par exemple des transistors de puissance, des thyristors de puissance, des diodes de puissance, des régulateurs, contrôleurs, amplificateurs, etc.

## Revendications

1. Module électronique de puissance (1) comportant au moins un semi-conducteur (5) relié à des conducteurs de raccordement (6, 7), **caractérisé en ce qu'**il comporte un support diélectrique (10) présentant d'une part une couche fixe (9), sur laquelle est monté au moins un desdits conducteurs de raccordement (6), et présentant d'autre part une couche mobile (11), la couche fixe (9) et la couche mobile (11) se superposant selon au moins une surface en vis-à-vis du au moins un conducteur de raccordement (6), l'écart entre la permittivité diélectrique de la couche mobile (11) et la permittivité diélectrique de la couche fixe (9) étant inférieur à 50 % de la permittivité diélectrique de la couche fixe (9).

2. Module selon la revendication 1, **caractérisé en ce que** l'écart entre la permittivité diélectrique de la couche mobile (11) et la permittivité diélectrique de la couche fixe (9) est inférieur à 20 % de la permittivité diélectrique de la couche fixe (9).

3. Module selon l'une des revendications 1 ou 2, **caractérisé en ce qu'**il comporte en outre un gel de remplissage (26) disposé autour du semi-conducteur (5) et des conducteurs de raccordement (6, 7), l'écart entre la permittivité diélectrique du gel de remplissage (26) et la permittivité diélectrique de la couche fixe (9) étant inférieur à 50 % de la permittivité diélectrique de la couche fixe (9).

4. Module selon l'une des revendications 1 à 3, **caractérisé en ce que** la couche mobile (11) est en contact avec la couche fixe (9) suivant une interface de contact texturée.

5. Module selon l'une des revendications 1 à 4, **caractérisé en ce que** la conductivité électrique de la couche mobile (11) et la conductivité électrique de la couche fixe (9) sont inclues dans un rapport 10.

6. Module selon l'une des revendications 1 à 5, **caractérisé en ce que** la couche fixe (9) présente une épaisseur inférieure à l'épaisseur critique d'isolation, compte tenu de la rigidité diélectrique de la couche fixe (9) et de la tension maximale du module électronique de puissance (1).

7. Module selon la revendication 6, **caractérisé en ce que** la somme de l'épaisseur de la couche fixe (9) et de l'épaisseur de la couche mobile (11) est supérieure à ladite épaisseur critique d'isolation.

8. Module selon l'une des revendications 1 à 7, **caractérisé en ce que** la couche fixe (9) est composée d'un substrat de céramique diélectrique.

9. Module selon l'une des revendications 1 à 8, **caractérisé en ce que** la couche mobile (11) est composée d'un fluide diélectrique.

10. Module selon la revendication 9, **caractérisé en ce que** le fluide diélectrique de la couche mobile (11) est contenu dans une chambre s'étendant suivant toute la surface de la couche fixe (9), la couche fixe (9) et la couche mobile (11) ayant ainsi des surfaces égales qui se superposent.

11. Module selon la revendication 9, **caractérisé en ce que en ce que** le fluide de la couche mobile (11) est contenu dans au moins une chambre restreinte (25) s'étendant seulement suivant la surface en regard du au moins un conducteur de raccordement (6), la couche fixe (9) et la couche mobile (11) se superposant ainsi sur toute la surface en regard du au moins un conducteur de raccordement (6).

12. Module selon la revendication 10 ou 11, **caractérisé en ce que** ladite chambre est une chambre fermée où la mobilité du fluide est assurée par convection.

13. Module selon la revendication 10 ou 11, **caractérisé en ce que** ladite chambre est connectée à un circuit de refroidissement.

14. Module selon l'une des revendications 9 à 13, **caractérisé en ce que** le fluide de la couche mobile (11) présente une température d'ébullition inférieure à la température du module électronique de puissance (1) en fonctionnement, de sorte à assurer un refroidissement diphasique.

## Patentansprüche

1. Elektronisches Leistungsmodul (1), das mindestens einen Halbleiter (5) aufweist, der mit Verbindungsleitern (6, 7) verbunden ist, **dadurch gekennzeichnet, dass** es einen dielektrischen Träger (10) aufweist, der einerseits eine feste Schicht (9) aufweist, auf der mindestens einer der Verbindungsleiter (6) montiert ist, und andererseits eine bewegliche Schicht (11) aufweist, wobei sich die feste Schicht (9) und die bewegliche Schicht (11) in mindestens einer Oberfläche überlappen, die dem mindestens einen Verbindungsleiter (6) zugewandt ist, wobei der Unterschied zwischen der Dielektrizitätskonstanten der beweglichen Schicht (11) und der Dielektrizitätskonstanten der festen Schicht (9) weniger als 50 % der Dielektrizitätskonstanten der festen Schicht (9) beträgt.

2. Modul nach Anspruch 1, **dadurch gekennzeichnet, dass** der Unterschied zwischen der Dielektrizitätskonstanten der beweglichen Schicht (11) und der Dielektrizitätskonstanten der festen Schicht (9) weniger als 20 % der Dielektrizitätskonstanten der festen Schicht (9) beträgt.

3. Modul nach einem der Ansprüche 1 oder 2, **dadurch gekennzeichnet, dass** es ferner ein Füllgel (26) aufweist, das um den Halbleiter (5) und die Verbindungsleiter (6, 7) herum angeordnet ist, wobei der Unterschied zwischen der dielektrischen Permittivität des Füllgels (26) und der dielektrischen Permittivität der festen Schicht (9) weniger als 50 % der dielektrischen Permittivität der festen Schicht (9) beträgt.

4. Modul nach einem der Ansprüche 1 bis 3, **dadurch gekennzeichnet, dass** die bewegliche Schicht (11) mit der festen Schicht (9) entlang einer texturierten Kontaktfläche in Kontakt steht.

5. Modul nach einem der Ansprüche 1 bis 4, **dadurch gekennzeichnet, dass** die elektrische Leitfähigkeit der beweglichen Schicht (11) und die elektrische Leitfähigkeit der festen Schicht (9) in einem Verhältnis von 10 enthalten sind.

6. Modul nach einem der Ansprüche 1 bis 5, **dadurch gekennzeichnet, dass** die feste Schicht (9) eine Dicke aufweist, die unter Berücksichtigung der dielektrischen Festigkeit der festen Schicht (9) und der maximalen Spannung des elektronischen Leistungsmoduls (1) geringer als die kritische Isolationsdicke ist.

7. Modul nach Anspruch 6, **dadurch gekennzeichnet, dass** die Summe der Dicke der festen Schicht (9) und der Dicke der beweglichen Schicht (11) größer als die kritische Isolationsdicke ist.

8. Modul nach einem der Ansprüche 1 bis 7, **dadurch gekennzeichnet, dass** die feste Schicht (9) aus einem dielektrischen Keramiksubstrat gebildet wird.

9. Modul nach einem der Ansprüche 1 bis 8, **dadurch gekennzeichnet, dass** die bewegliche Schicht (11) aus einem dielektrischen Fluid gebildet wird.

10. Modul nach Anspruch 9, **dadurch gekennzeichnet, dass** das dielektrische Fluid der beweglichen Schicht (11) in einer Kammer enthalten ist, die sich entlang der gesamten Oberfläche der festen Schicht (9) erstreckt, wobei die feste Schicht (9) und die bewegliche Schicht (11) gleiche, sich überlappende Oberflächen aufweisen.

11. Modul nach Anspruch 9, **dadurch gekennzeichnet, dass** das Fluid der beweglichen Schicht (11) in mindestens einer begrenzten Kammer (25) enthalten ist, die sich nur entlang der mindestens einem Verbindungsleiter (6) zugewandten Oberfläche erstreckt, wobei sich die feste Schicht (9) und die bewegliche Schicht (11) über die gesamte Oberfläche überlappen, die dem mindestens einen Verbindungsleiter (6) zugewandt ist.

12. Modul nach Anspruch 10 oder 11, **dadurch gekennzeichnet, dass** die Kammer eine geschlossene Kammer ist, in der die Beweglichkeit des Fluids durch Konvektion gewährleistet ist.

13. Das Modul nach Anspruch 10 oder 11, **dadurch gekennzeichnet, dass** die Kammer an einen Kühlkreislauf angeschlossen ist.

14. Modul nach einem der Ansprüche 9 bis 13, **dadurch gekennzeichnet, dass** das Fluid der beweglichen Schicht (11) eine Siedetemperatur aufweist, die niedriger als die Temperatur des elektronischen Leistungsmoduls (1) im Betrieb ist, so dass eine Zweiphasenkühlung gewährleistet ist

## Claims

1. Electronic power module (1) comprising at least one semiconductor (5) connected to connection conductors (6, 7), **characterized in that** it comprises a dielectric support (10) on the one hand exhibiting a fixed layer (9) on which at least one of said connection conductors (6) is mounted and on the other hand exhibiting a movable layer (11), the fixed layer (9) and the movable layer (11) being superposed along at least one surface facing the at least one connection conductor (6), the difference between the dielectric permittivity of the movable layer (11) and the dielectric permittivity of the fixed layer (9) being less than 50% of the dielectric permittivity of the fixed layer (9).

2. Module according to claim 1, **characterized in that** the difference between the dielectric permittivity of the movable layer (11) and the dielectric permittivity of the fixed layer (9) is less than 20 % of the dielectric permittivity of the fixed layer (9).

3. Module according to one of claims 1 or 2, **characterized in that** it further comprises a filler gel (26) disposed around the semiconductor (5) and connection conductors (6, 7), the difference between the dielectric permittivity of the filler gel (26) and the dielectric permittivity of the fixed layer (9) being less than 50 % of the dielectric permittivity of the fixed layer (9).

4. Module according to one of claims 1 to 3, **characterized in that** the movable layer (11) is in contact with the fixed layer (9) along a textured contact interface.

5. Module according to one of claims 1 a 4, **characterized in that** the electrical conductivity of the movable layer (11) and the electrical conductivity of the fixed layer (9) are within a ratio of 10.

6. Module according to one of claims 1 to 5, **characterized in that** the fixed layer (9) exhibits a thickness which is lower than the critical insulation thickness, taking account of the dielectric strength of the fixed layer (9) and the maximum voltage of the electronic power module (1).

7. Module according to claim 6, **characterized in that** the sum of the thickness of the fixed layer (9) and the thickness of the movable layer (11) is greater than said critical insulation thickness.

8. Module according to one of claims 1 to 7, **characterized in that** the fixed layer (9) is made up of a dielectric ceramic substrate.

9. Module according to one of claims 1 to 8, **characterized in that** the movable layer (11) is made up of a dielectric fluid.

10. Module according to claim 9, **characterized in that** the dielectric fluid of the movable layer (11) is contained in a chamber extending across the entire surface of the fixed layer (9), the fixed layer (9) and the movable layer (11) therefore having equal surfaces which are superposed.

11. Module according to claim 9, **characterized in that** the fluid of the movable layer (11) is contained within at least one smaller chamber (25) only extending across the surface facing the at least one connection conductor (6), the fixed layer (9) and the movable layer (11) therefore being superposed over the entire surface facing the at least one connection conductor (6).

12. Module according to claim 10 or 11, **characterized in that** said chamber is a sealed chamber in which the mobility of the fluid relies on convection.

13. Module according to claim 10 or 11, **characterized in that** said chamber is connected to a cooling circuit.

14. Module according to one of claims 9 to 13, **characterized in that** the fluid of the movable layer (11) exhibits a boiling temperature lower than the temperature of the electronic power module (1) when in operation, so as to provide two-phase cooling.
